# FASCICULE DE BREVET EUROPEEN

(11) **EP 0 666 481 B1**
(45) Date de publication et mention de la délivrance du brevet: **04.12.1996**
(21) Numéro de dépôt: 95470002.7
(22) Date de dépôt: 23.01.1995
(51) Int. Cl.: G01R 31/30, G11C 29/00, G06F 11/24, G11C 5/14

(54) **Circuit de sortie de tension analogique**
Analoge Spannung-Ausgangsschaltung
Analog voltage output circuit

(30) Priorité: 28.01.1994 FR 9400952
(43) Date de publication de la demande: 09.08.1995
(73) Titulaire: SGS-THOMSON MICROELECTRONICS S.A., 94250 Gentilly (FR)
(72) Inventeur: Drouot, Sylvie, Cabinet Ballot Schmit, F-57000 Metz (FR)
(74) Mandataire: Schmit, Christian Norbert Marie

(56) Documents cités:
- GB-A- 2 258 925
- US-A- 4 950 921
- US-A- 5 212 442

## Description

L'invention concerne les circuits intégrés. Plus particulièrement, elle concerne un circuit de sortie de tension analogique générée de manière interne dans un circuit intégré.

Le fonctionnement et l'utilisation de certains circuits intégrés peut amener leurs concepteurs à développer, par commodité, des circuits d'alimentation internes à ces circuits intégrés.

Dans une application donnée, nécessitant plusieurs circuits intégrés (microprocesseur, mémoire, convertisseurs, etc) rassemblés sur une même plaquette, on limite le nombre de circuits d'alimentation communs aux différents circuits, et donc externes à ceux-ci. Cela permet notamment de faciliter le routage des fils de connexion reliant ces circuits intégrés entre eux.

De manière générale les circuits intégrés sont alimentés entre au moins une masse et une tension analogique positive, par exemple 5V, utilisée entre autres pour alimenter les circuits logiques. Il sont parfois également alimentés par une deuxième tension analogique, par exemple 15V.

On est donc amené par convenance à développer des circuits d'alimentation internes à certains circuits intégrés afin de générer des tensions analogiques nécessaires au bon fonctionnement de ces circuits. Ces tensions analogiques sont générées à partir des tensions d'alimentation fournies au circuit intégré. Si le fonctionnement du circuit intégré nécessite une tension analogiques plus élevée, on peut par exemple utiliser des circuits de pompage, élévateur de tension. Par exemple, dans le cadre de l'utilisation d'une mémoire EPROM, on doit disposer d'une palette de tensions analogiques d'alimentation pour la lecture, l'écriture, et l'effacement éventuel de cellules de cette mémoire. Les valeurs de ces tensions analogiques varient en fonction de la technologie employée. Ces tensions analogiques ne sont pas nécessairement utiles dans d'autres circuits intégrés connectés à cette mémoire ou présents sur la même plaquette. De ce fait il n'est pas utile, voire judicieux, de prévoir un ou des circuits d'alimentation externes à la mémoire dont le seul but serait de fournir ces tensions analogiques à cette mémoire.

Afin de vérifier la validité d'un circuit intégré en cours de développement, on teste différents éléments critiques de ce circuit. D'éventuelles tensions d'alimentation générées de manière interne à ce circuit intégré font généralement partie de ces éléments critiques.

Auparavant, on mesurait les sorties des circuits d'alimentation internes avec des sondes. Physiquement, il s'agissait de poser une pointe métallique sur une piste conductrice connectée au niveau d'une sortie du circuit d'alimentation à tester. Or, on assiste à une diminution progressive des dimensions minimales de définition des circuits intégrés. Pour des dimensions de piste de l'ordre de quelques micromètres, des problèmes de sensibilité mécanique et électrique se posent. La moindre vibration mécanique oblige pratiquement à repositionner la pointe métallique, et accroît donc le temps nécessaire à la mesure. D'autre part, comme cette pointe doit avoir une largeur de l'ordre des pistes conductrices, elle est sensible aux phénomènes de rayonnement électromagnétiques qui faussent les résultats de mesure. Il est donc difficile, voire impossible de tester la ou les valeurs des tensions analogiques délivrées par un ou plusieurs circuits d'alimentation interne.

Il est donc apparu nécessaire de réaliser des circuits de sortie des tensions analogiques , afin de tester la valeur de ces tensions analogiques sur des broches de connexion du circuits intégré.

Outre le fait que cela induit un encombrement supplémentaire, cela nécessite de dédier au moins une broche de connexion du circuit intégré à la sortie de la ou des tensions analogiques qu'on souhaite mesurer. Or on souhaite minimiser le nombre de broches de connexion du circuits intégrés pour en limiter ses dimensions. D'autre part, une sortie de test d'une alimentation interne est utilisée en phase de développement et n'est pas vouée à être utilisée par un utilisateur final. Ce dernier a peu intérêt à utiliser un circuit intégré dont une ou plusieurs connexions seraient inutilisables pour son application.

Il se peut qu'on découvre, en cours de développement, un dysfonctionnement d'une partie du circuit intégré connectée à un circuit d'alimentation interne. Il est alors utile de tester si le circuit d'alimentation fournit bien la tension analogique attendue. En cas de réponse négative, il est toujours intéressant de vérifier la réaction du circuit intégré si la tension analogique désirée est fournie à ce circuit. Il parait donc avantageux de pouvoir imposer par l'extérieur la tension analogique attendue.

La demande de brevet US-A-4 950 921 concerne une mémoire comprenant un ircuit générateur de tension délivrant une tension interne, et une borne pour recevoir une tension d'alimentation. Il comprend un circuit de contrôle de test de vieillissement pour relier une ligne d'alimentation interne pour fournir à des circuits internes, soit la tension interne, soit la tension d'alimentation.

Cette mémoire ne comporte pas de circuit de sortie de la tension interne sur une borne de sortie pouvant servir soit en borne de test soit pour un autre usage.

La demande de brevet GB-A-2 258 925 concerne également un circuit comprenant un générateur de tension et des moyens de commande pour effectuer des tests de vieillissement. Dans ce circuit, le générateur produit deux tensions internes différentes suivant la tension appliquée sur une borne du circuit.

Ce circuit ne comporte pas non plus de circuit de sortie sur une borne de test de la tension produite, cette borne pouvant servir soit en borne de test, soit pour un autre usage.

La demande de brevet US-A-5 212 442 concerne un circuit équipé pour mettre son substrat à un potentiel donné.

Au vu de ce qui précède, le but de la présente invention est de proposer un circuit de test répondant à une triple fonctionnalité :
- possibilité de test de la ou des valeurs d'une ou plusieurs tensions analogiques générées par des circuits d'alimentation internes à un circuit intégré, cette ou ces valeurs étant accessibles sur une ou des broches de connexion du circuit intégré,
- possibilité de forçage de cette ou ces valeurs générées extérieurement au circuit intégré, cette ou ces valeurs étant appliquées sur des broches de connexion du circuit intégré,
- possibilité d'isoler, en fonctionnement normal, les circuits d'alimentations internes des broches de connexion utilisées pour la mesure ou le forçage d'une tension analogique.

La dernière fonction décrite permet d'utiliser éventuellement une broche de connexion, utilisée pour le test (mesure ou forçage), pour un autre usage en utilisation normale. On évite ainsi la présence de broches de connexion non utilisables dans la version client (destinée à la vente) du circuit intégré.

Suivant l'invention, ce but est atteint par un circuit intégré comprenant des bornes de référence pour fournir respectivement une ou des tensions de base et une ou des tensions d'alimentation, un ou des circuits d'alimentation interne comprenant au moins une borne interne d'entrée pour recevoir une tension d'alimentation, au moins une borne interne de sortie pour délivrer une tension d'alimentation interne, et au moins une borne de commande pour recevoir un signal impulsionnel de mise en marche, une borne de test et une borne de commande de test, ladite borne de test pouvant recevoir ou fournir une tension de test, et ladite borne de commande de test pouvant recevoir un signal impulsionnel de commande de test, un circuit de sortie de tension analogique connecté respectivement à la borne de sortie, à la borne de test, à la borne de commande de test, à une ou des bornes de référence, ce circuit de sortie de tension analogique comprenant des transistors d'isolement connectés en série entre la borne de sortie et la borne de test et un ou plusieurs circuits de commutation, caractérisé en ce qu'un premier circuit de commutation connecte la grille de commande d'un premier transistor d'isolement respectivement à la borne de test quand le signal de commande de test est dans un premier état, à une borne de référence quand le signal de commande de test est dans un second état.

Dans un mode de réalisation préféré un deuxième circuit de commutation connecte la grille de commande d'un deuxième transistor d'isolement respectivement à la borne interne de sortie quand le signal de commande de test est dans son premier état, et à une borne de référence quand le signal de commande de test est dans son second état.

Ainsi, le circuit suivant l'invention permet d'une part d'isoler la borne interne de sortie et la borne de test quand le signal de commande de test est dans son premier état, et d'autre part de connecter la borne interne de sortie et la borne de test quand le signal de commande de test est dans un second état.

Pour isoler la borne interne de sortie et la borne de test, on connecte les grilles de transistors d'isolement sur ces bornes. Ainsi, quelles que soient les valeurs de tension présentes sur ces bornes, ces transistors sont bloqués.

Avantageusement, le premier et le deuxième transistors d'isolement sont des transistors de type P. Ces transistors présentent un double avantage. Premièrement, on minimise les chutes de tension entre la sortie du circuit d'alimentation interne et la borne de test. Deuxièmement, on peut commander la connexion de la borne interne de sortie et la borne de test en mettant leur grille de commande à la masse. On peut donc forcer facilement une tension extérieure sur la borne de sortie, quelle que soit la tension présente sur la borne interne de sortie.

Ces transistors étant montés en série, on connectera avantageusement le point milieu de ces transistors au drain d'un transistor de type N dont la source est connectée à une borne de référence et dont la grille de commande est connectée à la grille de commande du deuxième transistor d'isolement. Ainsi, en connectant par ailleurs les substrats des transistors d'isolement respectivement à la borne de test et à la borne de sortie, on assure un parfait isolement entre les dites bornes.

D'autres particularités et avantages de la présente invention apparaîtront dans la description détaillée ci après d'un exemple de réalisation préféré, donné à titre indicatif et nullement limitatif.

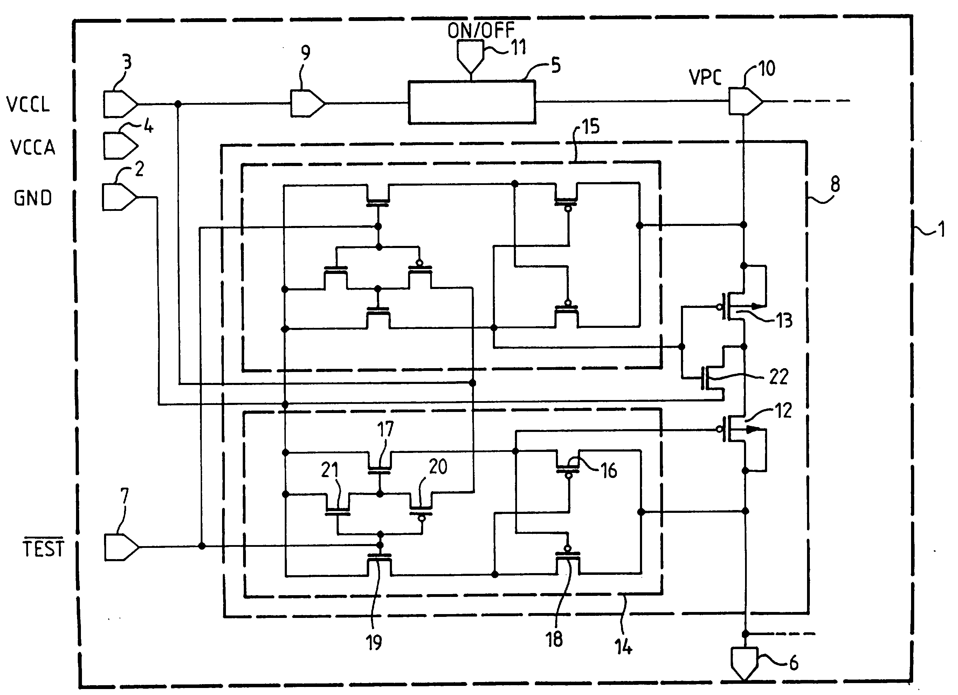

La figure 1 unique illustre un exemple de circuit intégré 1 comprenant un circuit de sortie de tension analogique 2 suivant l'invention.

Ce circuit intégré 1 comprend :
- des bornes de référence 2, 3, et 4 pour fournir respectivement une ou des tensions de base et une ou des tensions d'alimentation,
- un circuit d'alimentation interne 5,
- une borne de test 6 et une borne de commande de test 7,
- un circuit de sortie de tension analogique 8.

Dans l'exemple décrit, le circuit intégré 1 comprend trois bornes de référence 2, 3 et 4. Ces bornes de référence fournissent une ou des tensions au circuit intégré 1. Par fourniture, on entend que ces tensions sont générées par des circuits d'alimentation externes au circuit intégré 1. Les bornes de référence 2, 3 et 4 sont donc en pratique des broches de connexion du circuit intégré 1.

La borne de référence 2 fournit une tension dite de base GND. En pratique il s'agit d'une masse.

La borne de référence 3 et 4 fournissent respectivement une première tension d'alimentation VCCL et une deuxième tension d'alimentation VCCA.

Dans l'exemple considéré, la première tension d'alimentation VCCL correspond à une tension alimentant des circuits logiques. Pratiquement cette tension d'alimentation logique VCCL a un niveau de 3 à 5 volts. La deuxième tension d'alimentation VCCA correspond à une tension analogique, ayant un niveau compris par exemple entre 12 et 15 volts. Ce type d'alimentation analogique VCCA est utilisé typiquement pour le fonctionnement de mémoires de type EPROM qui nécessitent des hautes tensions (jusqu'à 20 volts), par exemple pour la programmation et l'effacement (dans le cas des EEPROM) des cellules de ces mémoires. En effet, il est plus simple et surtout plus économique d'élever une tension d'une faible valeur, 12 à 17 volts par exemple, que d'une forte valeur, 5 à 17 volts par exemple.

On pourrait bien sûr considérer un exemple de circuit alimenté par une seule tension d'alimentation externe.

Le circuit d'alimentation interne 5 comprend :
- une borne interne d'entrée 9 pour recevoir une tension d'alimentation,
- une borne interne de sortie 10 pour délivrer une tension d'alimentation interne VPC, et
- une borne de commande 11 pour recevoir un signal impulsionnel de mise en marche.

On ne considère qu'un seul circuit d'alimentation interne 5. Néanmoins, suivant les besoins en valeurs de tensions nécessaires au fonctionnement du circuit intégré 1, on pourrait considérer plusieurs circuits d'alimentation internes.

La composition et le fonctionnement du circuit d'alimentation interne 5 ne seront pas décrits exhaustivement dans la suite de la description. Classiquement on utilise par exemple des circuits de pompage de type Schenkel.

Typiquement le circuit d'alimentation interne 5 reçoit sur sa borne interne d'entrée 9 une tension d'alimentation externe, VCCL ou VCCA. Il génère, à partir de cette tension d'alimentation externe, une tension d'alimentation interne VPC. Cette tension d'alimentation interne VPC est fournie au reste du circuit intégré 1 sur sa borne interne de sortie 10. Par interne, on entend non accessible de l'extérieur du circuit intégré 1, par opposition à des broches de connexion qui, elles, le sont.

La borne de commande 11 reçoit un signal de commande binaire ON/OFF. Ce signal ON/OFF est utilisé pour mettre en marche, à l'état ON, ou arrêter, à l'état OFF, le circuit d'alimentation interne 5. La présence d'un tel signal ON/OFF n'est pas obligatoire. On pourrait imaginer que le circuit d'alimentation interne 5 fonctionne constamment. Néanmoins, il est intéressant fonctionnellement de disposer d'un tel signal de commande. En effet, on souhaite pouvoir forcer une tension générée extérieurement au circuit intégré, en lieu et place de la tension d'alimentation VPC. Il est recommandé, dans ce cas, de pouvoir isoler la borne interne de sortie 10 du circuit d'alimentation interne 5 afin d'éviter un éventuel court-circuit entre le circuit d'alimentation interne 5 et un circuit d'alimentation externe. D'autre part, de manière plus générale, il est avantageux de limiter la consommation du circuit intégré 1. On cherche donc en général à couper la consommation de parties de ce circuit qui ne sont pas utilisées.

Dans la suite de la description, on considérera que GND vaut 0V, que VCCL vaut 5V, que VCCA vaut 12V, et que VPC vaut 7V. On supposera que VPC est générée à partir de VCCL et que la borne interne d'entrée 9 est connectée à la borne d'alimentation logique 3.

La borne de test 6 peut recevoir ou fournir une tension de test. Cette borne de test 6 est une broche de connexion du circuit intégré 1. C'est en se connectant sur cette borne de test 6 que l'on peut mesurer la tension d'alimentation VPC ou imposer une tension sur la borne interne de sortie 10 du circuit d'alimentation interne 5.

La borne de commande de test 7 peut recevoir un signal impulsionnel de commande de test /TEST. Le signal de commande de test /TEST peut prendre deux valeurs correspondant en pratique à VCCL et à GND. Ces valeurs de tension correspondent à des états logiques 0 et 1. /TEST=0 correspond à la valeur de tension GND. /TEST=1 correspond à la valeur de tension VCCL. Quand le signal de commande de test /TEST est à 0 logique, on peut mesurer ou forcer une tension sur la borne interne de sortie 10. Quand le signal de commande de test /TEST est à 1 logique, on isole la borne interne de sortie 10 de la borne de test 6.

Pratiquement, la borne de commande de test 7 est soit une broche de connexion du circuit intégré 1, soit une borne interne. Si c'est une broche de connexion, on pourra éventuellement l'utiliser dans un autre but dans la version client. Si c'est une borne interne, le signal de commande de test /TEST est alors généré de manière interne au circuit intégré 1. Classiquement, c'est la deuxième solution qui est préférée, le signal /TEST étant produit à partir d'une séquence de code fournie au circuit intégré.

Le circuit de sortie de tension analogique 8, est connecté respectivement à :
- la borne interne de sortie 10,
- la borne de test 6,
- la borne de commande de test 7,
- aux bornes de référence 2 et 3.

Ce circuit de sortie de tension analogique 8 comprend des transistors d'isolement 12 et 13 connectés en série entre la borne interne de sortie 10 et la borne de test 6. Les transistors d'isolement 12 et 13, ainsi que les transistors décrits ci-après, seront par exemple des transistors de type MOS. Il comprend également des circuits de commutation 14 et 15.

Un premier circuit de commutation 14 connecte la grille de commande d'un premier transistor d'isolement 12 respectivement :
- à la borne de test 6 quand le signal de commande de test /TEST est à 1,
- à la borne de base 2 quand le signal de commande de test /TEST est à 0.

Ce premier circuit de commutation 14, réalisé de façon classique, comprend :
- deux entrées,
- une sortie connectée à l'une ou l'autre entrée,
- une commande,

Deux transistors 16 et 17, respectivement de type P et de type N sont montés en série entre la borne de test 6 et la borne de base 2. La borne de test 6 et la borne de base 2 sont les entrées du circuit de commutation 14. La source du transistor P 16 est connectée à la borne de test 6. La source du transistor N 17 est connectée à la borne de base 2. Les drains de ces deux transistors 16 et 17 sont connectés entre eux et constituent la sortie du circuit de commutation 14, celle-ci étant elle-même connectée à la grille de commande du premier transistor d'isolement 12.

Le premier circuit de commutation 14 comprend deux autres transistors 18 et 19, de types respectifs P et N, dont les sources sont montées de manière similaire à celles des premiers transistors 16 et 17, et dont les drains sont de même connectés entre eux.

La grille de commande du premier transistor de type P 16 est connectée au drain du deuxième transistor de type P 18. De même, la grille de commande du deuxième transistor de type P 18 est connectée au drain du premier transistor de type P 16.

La grille de commande du deuxième transistor de type N 19 est connectée à la borne de commande de test 7. La grille de commande du premier transistor de type N 17 l'est également, par le biais d'un inverseur comprenant classiquement deux transistors de types opposés 20 et 21 montés en série entre la borne d'alimentation logique 3 et la borne de base 2. La commande du circuit de commutation 14 dépend ainsi du signal de commande de test /TEST.

Un deuxième circuit de commutation 15 connecte la grille de commande d'un deuxième transistor d'isolement 13 respectivement :
- à la borne interne de sortie 10 quand le signal de commande de test /TEST est à 1,
- à la borne de base 2 quand le signal de commande de test /TEST est à 0.

Ce deuxième circuit de commutation 15 est réalisé de manière équivalente au premier circuit de commutation 14, à une différence près. En effet les entrées de ce circuit sont la borne interne de sortie 10 et la borne de base 2, et non la borne de test 6 et la borne de base 2.

Le premier transistor d'isolement 12 est un transistor de type P dont la source et le substrat sont connectés à la borne de test 6.

Le deuxième transistor d'isolement 13 est un transistor de type P dont la source et le substrat sont connectés à la borne interne de sortie 10, et dont le drain est connecté au drain du premier transistor d'isolement 12.

On préférera les transistors de type P pour la justesse de la mesure. En effet, des transistors de type N montés de la façon indiquée précédemment, induiraient des chutes de tension (effet de seuil et effet substrat) pouvant atteindre 2 volts par transistor. La tension mesurée serait donc relativement éloignée de la tension réellement présente au niveau de la borne interne de sortie 10. Par exemple, on mesurera 4 volts au lieu de 7V. Pour minimiser ces pertes, on pourrait envisager de connecter les grilles de commande de ces transistors à une borne d'alimentation fournissant une tension d'alimentation plus élevée, par exemple VCCA (12V). Cela compliquerait le schéma d'implantation, ce qui n'est pas souhaitable. D'autre part, il faudrait encore être certain que la tension VPC ne pourra jamais dépasser ladite tension d'alimentation VCCA.

Le circuit de test 8 isole la borne interne de sortie 10 et la borne de test 6 quand le signal de commande de test /TEST est à 1. En effet, les grilles de commande des transistors d'isolement 12 et 13 sont alors connectées à leurs sources. Ils sont donc bloqués, quelles que soient les tensions présentes sur les bornes 10 et 6.

Le circuit de sortie de tension analogique 8 connecte la borne interne de sortie 10 et la borne de test 6 quand le signal de commande de test /TEST est à 0. En effet, les grilles de commande des transistors d'isolement 12 et 13 sont alors connectées à la borne de base 2.

Dans ce cas, on pourra sans difficulté isoler le circuit d'alimentation interne 5 de sa borne interne de sortie 10. En effet, le fait de bloquer ou de rendre passant le deuxième transistor d'isolement 13 est indépendant de la valeur de la tension d'alimentation interne VPC. Dans le premier cas, la grille de commande et la source de ce transistor sont connectées. Dans le deuxième cas, la grille de commande de ce transistor est connectée à la borne de base 2, pour peu que VCCL soit bien positive. Si on souhaite forcer une tension sur la borne de test 6, on pourra donc isoler le circuit d'alimentation interne 5 et la borne interne de sortie 10.

Avantageusement, on connectera les drains des transistors d'isolement 12 et 13 au drain d'un transistor de type N 22 dont la source est connectée à la borne de base 2 et dont la grille de commande est connectée à la grille de commande du deuxième transistor d'isolement 13. On assure alors un parfait isolement, en fonctionnement normal, entre la borne interne de sortie 10 et la borne de test 6. En effet, les substrats des transistors d'isolement 12 et 13 sont alors de manière certaine à un potentiel supérieure ou égal aux potentiels des sources et drains de ces transistors. On évite ainsi l'apparition de fuites qui seraient dues à un potentiel flottant au niveau des drains des transistors d'isolement 12 et 13.

En ce qui concerne le rapport entre la largeur de la grille de commande et la longueur de la dite grille, exprimé en micromètres, on prendra par exemple :
- 30/6 pour le premier transistor d'isolement 12, et de
- 15/3 pour le deuxième transistor d'isolement 13.

On a décrit ci-dessus un mode préféré de réalisation de l'invention.

Ce mode n'est pas limitatif. En particulier, on pourrait dupliquer le circuit de sortie de tension analogique afin de tester des circuits d'alimentation internes différents, en dupliquant également le nombre de signals de commande de test. Il n'y aurait aucune difficulté pour connecter ces circuits à une même borne de test. En effet, en étant attentif à ne pas mettre à 0 plus d'un signal de commande de test à la fois, on serait certain que ces circuits seraient isolés entre eux.

## Revendications

1. Circuit intégré (1) comprenant :
- des bornes de référence (2, 3, 4) pour fournir respectivement une ou des tensions de base (GND) et une ou des tensions d'alimentation (VCCL, VCCA),
- un circuit d'alimentation interne (5) comprenant au moins une borne interne d'entrée (9) pour recevoir une tension d'alimentation, au moins une borne interne de sortie (10) pour délivrer une tension d'alimentation interne (VPC), et au moins une borne de commande (11) pour recevoir un signal impulsionnel de mise en marche (ON/OFF),
- une borne de test (6) et une borne de commande de test (7), ladite borne de test (6) pouvant recevoir ou fournir une tension de test, et ladite borne de commande de test (7) pouvant recevoir un signal impulsionnel de commande de test (/TEST),
- un circuit de sortie de tension analogique (8) connecté respectivement à la borne interne de sortie (10), à la borne de test (6), à la borne de commande de test (7), à une ou des bornes de référence (2, 3), ce circuit de sortie de tension analogique (8) comprenant des transistors d'isolement (12, 13) connectés en série entre la borne interne de sortie (10) et la borne de test (6), et un ou plusieurs circuits de commutation (14, 15),
caractérisé en ce qu'un premier circuit de commutation (14) connecte la grille de commande d'un premier transistor d'isolement (12) respectivement :
- à la borne de test (6) quand le signal de commande de test (/TEST) est dans un premier état,
- à une borne de référence (2) quand le signal de commande de test (/TEST) est dans un second état.

2. Circuit selon la revendication 1, caractérisé en ce qu'un deuxième circuit de commutation (15) connecte la grille de commande d'un deuxième transistor d'isolement (13) respectivement :
- à la borne interne de sortie (10) quand le signal de commande de test (/TEST) est dans son premier état,
- à une borne de référence (2) quand le signal de commande de test (/TEST) est dans son second état.

3. Circuit selon la revendication 2, caractérisé en ce que le circuit de sortie de tension analogique (8) isole la borne interne de sortie (10) et la borne de test (6) quand le signal de commande de test (/TEST) est dans son premier état, et en ce qu'il connecte la borne interne de sortie (10) et la borne de test (6) quand le signal de commande de test (/TEST) est dans son second état.

4. Circuit selon la revendication 1, caractérisé en ce que le premier transistor d'isolement (12) est un transistor de type P dont la source et le substrat sont connectés à la borne de test (6).

5. Circuit selon la revendication 2, caractérisé en ce que le deuxième transistor d'isolement (13) est un transistor de type P dont la source et le substrat sont connectés à la borne interne de sortie (10), et dont le drain est connecté au drain du premier transistor d'isolement (12).

6. Circuit selon la revendication 5, caractérisé en ce que les drains des transistors d'isolement (12, 13) sont connectés au drain d'un transistor de type N (22) dont la source est connectée à une borne de référence (2) et dont la grille de commande est connectée à la grille de commande du deuxième transistor d'isolement (13).

7. Circuit selon la revendication 2, caractérisé en ce que le rapport entre la largeur de la grille de commande et la longueur de la dite grille, exprimé en micromètres, est de :
- 30/6 pour le premier transistor d'isolement (12), et de
- 15/3 pour le deuxième transistor d'isolement (13).

## Patentansprüche

1. Integrierte Schaltung (1), die umfaßt:
- Bezugsklemmen (2, 3, 4) zum Liefern jeweils einer oder mehrerer Grundspannungen (GND) und einer oder mehrerer Versorgungsspannungen (VCCL, VCCA),
- eine interne Versorgungsschaltung (5), die mindestens eine interne Eingangsklemme (9) umfaßt, die eine Versorgungsspannung empfangen soll, mindestens eine interne Ausgangsklemme (10) zum Liefern einer internen Versorgungsspannung (VPC), und mindestens eine Steuerklemme (11), die ein Start-Impulssignal (ON/OFF) empfangen soll,
- eine Testklemme (6) und eine Test-Steuerklemme (7), wobei die Testklemme (6) eine Testspannung empfangen oder liefern kann, und wobei die Test-Steuerklemme (7) ein Test-Steuerimpulssignal (/TEST) empfangen kann,
- eine Analogspannungs-Ausgangsschaltung (8), die jeweils mit der internen Ausgangsklemme (10), mit der Testklemme (6), der Test-Steuerklemme (7), mit einer oder mehreren Bezugsklemmen (2, 3) verbunden ist, wobei diese Analogspannungs-Ausgangsschaltung (8) Trenntransistoren (12, 13) umfaßt, die in Serie zwischen der internen Ausgangsklemme (10) und der Testklemme (6) geschaltet sind, und einen oder mehrere Schaltkreise (14, 15),
dadurch gekennzeichnet, daß ein erster Schaltkreis (14) das Steuergitter eines ersten Trenntransistors (12) jeweils verbindet mit:
- der Testklemme (6), wenn sich das Test-Steuersignal (/TEST) in einem ersten Zustand befindet,
- mit einer Bezugsklemme (2), wenn sich das Test-Steuersignal (/TEST) in einem zweiten Zustand befindet.

2. Schaltung nach Anspruch 1, dadurch gekennzeichnet, daß ein zweiter Schaltkreis (15) das Steuergitter eines zweiten Trenntransistors (13) jeweils verbindet mit:
- der internen Ausgangsklemme (10), wenn sich das Test-Steuersignal (/TEST) in seinem ersten Zustand befindet,
- mit einer Bezugsklemme (2), wenn sich das Test-Steuersignal (/TEST) in seinem zweiten Zustand befindet.

3. Schaltung nach Anspruch 2, dadurch gekennzeichnet, daß die Analogspannungs-Ausgangsschaltung (8) die interne Ausgangsklemme (10) und die Testklemme (6) trennt, wenn sich das Test-Steuersignal (/TEST) in seinem ersten Zustand befindet, und daß sie die interne Ausgangsklemme (10) und die Testklemme (6) verbindet, wenn sich das Test-Steuersignal (/TEST) in seinem zweiten Zustand befindet.

4. Schaltung nach Anspruch 1, dadurch gekennzeichnet, daß der erste Trenntransistor (12) ein P-Transistor ist, dessen Quelle und Substrat mit der Testklemme (6) verbunden sind.

5. Schaltung nach Anspruch 2, dadurch gekennzeichnet, daß der zweite Trenntransistor (13) ein P-Transistor ist, dessen Quelle und Substrat mit der internen Ausgangsklemme (10) verbunden sind und dessen Drain mit dem Drain des ersten Trenntransistors (12) verbunden ist.

6. Schaltung nach Anspruch 5, dadurch gekennzeichnet, daß die Drains der Trenntransistoren (12, 13) mit dem Drain eines N-Transistors (22) verbunden sind, dessen Quelle mit einer Bezugsklemme (2) verbunden ist, und dessen Steuergitter mit dem Steuergitter des zweiten Trenntransistors (13) verbunden ist.

7. Schaltung nach Anspruch 2, dadurch gekennzeichnet, daß das Verhältnis zwischen der Breite des Steuergitters und der Länge dieses Gitters in Mikrometer ausgedrückt folgendes ist:
- 30/6 beim ersten Trenntransistor (12), und
- 15/3 beim zweiten Trenntransistor (13).

## Claims

1. Integrated circuit (1) comprising:
- reference terminals (2, 3, 4) for supplying respectively one or more base voltages (GND) and one or more supply voltages (VCCL, VCCA),
- an internal supply circuit (5) comprising at least one internal input terminal (9) for receiving a supply voltage, at least one internal output terminal (10) for delivering an internal supply voltage (VPC), and at least one control terminal (11) for receiving a pulsed start signal (ON/OFF),
- a test terminal (6) and a test control terminal (7), the said test terminal (6) being able to receive or supply a test voltage, and the said test control terminal (7) being able to receive a pulsed control test signal (/TEST),
- an analogue voltage output circuit (8) connected respectively to the internal output terminal (10), to the test terminal (6), to the test control terminal (7) and to one or more reference terminals (2, 3), this analogue voltage output circuit (8) comprising isolation transistors (12, 13) connected in series between the internal output terminal (10) and the test terminal (6), and one or more switching circuits (14, 15),
characterised in that a first switching circuit (14) connects the control gate of a first isolation transistor (12) respectively:
- to the test terminal (6) when the test control signal (/TEST) is in a first state,
- to a reference terminal (2) when the test control signal (/TEST) is in a second state.

2. Circuit according to Claim 1, characterised in that a second switching circuit (15) connects the control gate of a second isolation transistor (13) respectively:
- to the internal output terminal (10) when the test control signal (/TEST) is in its first state,
- to a reference terminal (2) when the test control signal (/TEST) is in its second state.

3. Circuit according to Claim 2, characterised in that the analogue voltage output circuit (8) isolates the internal output terminal (10) and the test terminal (6) when the test control signal (/TEST) is in its first state, and in that it connects the internal output terminal (10) and the test terminal (6) when the test control signal (/TEST) is in its second state.

4. Circuit according to Claim 1, characterised in that the first isolation transistor (12) is a p-type transistor whose source and substrate are connected to the test terminal (6).

5. Circuit according to Claim 2, characterised in that the second isolation transistor (13) is a p-type transistor whose source and substrate are connected to the internal output terminal (10) and whose drain is connected to the drain of the first isolation transistor (12).

6. Circuit according to Claim 5, characterised in that the drains of the isolation transistors (12, 13) are connected to the drain of an n-type transistor (22) whose source is connected to a reference terminal (2) and whose control gate is connected to the control gate of the second isolation transistor (13).

7. Circuit according to Claim 2, characterised in that the ratio between the width of the control gate and the length of the said gate, expressed in micrometres, is:
- 30/6 for the first isolation transistor (12), and
- 15/3 for the second isolation transistor (13).
